Europäisches Patentamt

(19) European Patent Office

Office européen des brevets

(11) Publication number: **0 024 320**
**B1**

(12) **EUROPEAN PATENT SPECIFICATION**

(45) Date of publication of patent specification: **23.04.86**

(51) Int. Cl.⁴: **H 01 L 29/66, H 01 L 29/743**

(21) Application number: **80104550.1**

(22) Date of filing: **31.07.80**

(54) **Method of manufacturing thermally sensitive semiconductor switch.**

(30) Priority: **16.08.79 JP 104806/79**

(43) Date of publication of application:
**04.03.81 Bulletin 81/09**

(45) Publication of the grant of the patent:
**23.04.86 Bulletin 86/17**

(84) Designated Contracting States:
**DE NL SE**

(56) References cited:
**EP-A-0 012 846**
**FR-A-1 502 247**
**US-A-4 009 482**

**TECHNICAL DIGEST OF THE INTERNATIONAL ELECTRON DEVICES MEETING, Washington, 6th-8th December 1976, pages 275-278, IEEE, New York, USA J. NAKATA et al.: "Thermosensor - A new temperature-sensitive switching device"**

**ELECTRONICS, vol. 46, no. 6, 15th March 1973, pages 149-150, New York, USA "Semiconductors"**

(73) Proprietor: **MITSUBISHI DENKI KABUSHIKI KAISHA**
**2-3, Marunouchi 2-chome Chiyoda-ku Tokyo 100 (JP)**

(72) Inventor: **Tada, Akiharu**
**10, Mizuhara 3-chome**
**Itami, Hyogo Prefecture (JP)**
Inventor: **Gamo, Hiroshi**
**24-15, Uguisudani 2-chome**
**Kawanishi Hyogo Prefecture (JP)**

(74) Representative: **Kern, Ralf M., Dipl.-Ing.**
**Kern, Lang, Barg & Partner Patent- und Rechtsanwältsbüro Postfach 14 03 29**
**D-8000 München 5 (DE)**

Courier Press, Leamington Spa, England.

# Description

This invention relates to a method of manufacturing a thermally sensitive semiconductor switch using a thermally sensitive thyristor having a *pnpn* junction structure, and more particularly to a method of manufacturing a thermally sensitive switch semiconductor having a predetermined switching temperature.

Thermally sensitive thyristors of the *pnpn* junction structure have the property that they switch from their OFF to their ON state at the temperature inherent to the characteristics of the *pnpn* junction structure by fixing both the gate resistance connected across the gate and anode electrodes thereof and the voltage applied across the anode and cathode electrode thereof.

Those thermally sensitive thyristors are used as temperature sensors by utilizing the above-mentioned property thereof. To this end, it is required to switch the thyristors at the predetermined temperature which is called a switching temperature and also to control the switching temperature to be in a range of from +3° to −3°C and preferably, from +2° to −2°C about a predetermined switching temperature for practical purposes. However, the existing methods of manufacturing semiconductor thermally sensitive switches of the *pnpn* junction structure have resulted in switching temperatures being distributed in a range of from +7° to −7°C about the particular predetermined switching temperature. If the switching temperatures are selected to be in the required range of from +3° to −3°C about the predetermined magnitude, then the resulting yield has decreased to from 20 to 30%. This has led to one of the causes for which thermally sensitive semiconductor switches increase in cost.

Accordingly it is an object of the present invention to provide a new and improved method of manufacturing a semiconductor thermally sensitive switch having a predetermined switching temperature in a simple and reliable manner.

The present invention provides a method of manufacturing a thermally sensitive semiconductor switch comprising a semiconductor element of the *pnpn* junction structure including a gate resistor connected across a gate electrode disposed in ohmic contact with a central base layer of the semiconductor element and one main electrode disposed in ohmic contact with an emitter layer thereof adjacent to the central base layer which method comprises the steps of forming the gate resistor of a thick film resistance low in resistance so as to render a switching temperature of the semiconductor thermally sensitive switch higher than a predetermined magnitude thereof, holding the thermally sensitive semiconductor switch at a temperature equal to the predetermined switching temperature, cutting the gate resistor to increase the resistance thereof while a predetermined anode voltage is applied across the semiconductor element, and stopping the cutting of the gate resistor upon the semiconductor thermally sensitive switch changing from its OFF to its ON state thereby to fix the resistance of the gate resistor.

Preferably the step of cutting the gate resistor may be effected according to sand-blasting or laser-trimming technique.

The present invention will become more readily apparent from the following detailed description taken in conjunction with the accompanying drawing in which:

Figure 1 is a schematic diagram of a typical structure of a thermally sensitive thyristor;

Figure 2 is a graph illustrating, by way of example, the relationship between a resistance of the gate resistor shown in Figure 1 and a switching temperature of the arrangement shown in Figure 1; and

Figure 3 is a perspective view illustrating one embodiment according to the manufacturing method of the present invention.

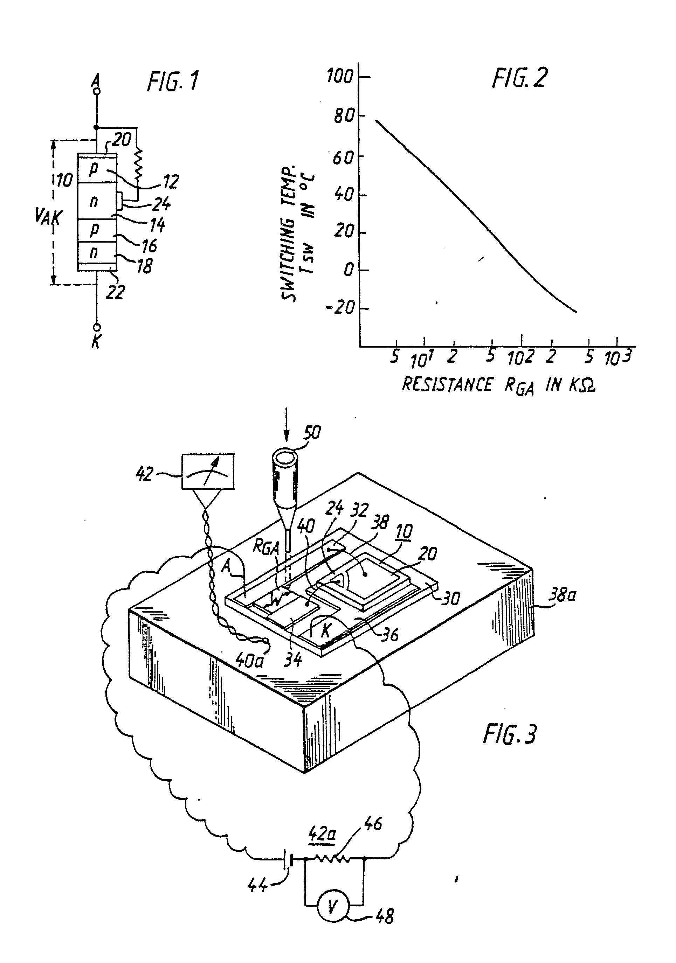

Referring now to Figure 1 of the drawing, there is illustrated a typical structure of a thermally sensitive thyristor. The arrangement illustrated comprises a semiconductor element generally designated by the reference numeral 10 including a *p* type first emitter layer 12, an *n* type first base layer 14, a *p* type second base layer 16 and an *n* type second emitter layer 18 interconnected in the named order to form a *pnpn* junction structure. Then an anode electrode 20 is disposed in ohmic contact with the *p* type first emitter layer 12 forming an anode region and connected to an anode terminal A while a cathode electrode 22 is disposed in ohmic contact with the *n* type second emitter layer 18 forming a cathode region and connected to a cathode terminal K. Also a gate electrode 24 is disposed in ohmic contact with the *n* type first base layer 14 adjacent to the *p* type first emitter layer 12 and forming a gate region. A gate resistor $R_{GA}$ is connected across the anode and gate electrodes 20 and 24 respectively.

The semiconductor element 10 is thermally coupled to a heat source such as a heating resistor (not shown) to be heated thereby until it switches from its OFF to its ON state at a predetermined temperature. That temperature is called a "switching temperature designated by the $T_{SW}$". When the gate resistor $R_{GA}$ has a fixed magnitude of resistance and a constant voltage is applied across the anode and cathode electrodes 20 and 22 respectively, the switching temperature is inherent to the characteristics of the *pnpn* structure.

The switching temperature $T_{SW}$ changes with a resistance of the gate resistor $R_{GA}$ as shown in Figure 2 wherein the switching temperature $T_{SW}$ in degrees centigrade is plotted in ordinate against the resistance of the gate resistor $R_{GA}$ in kiloohms in a logarithmic scale in abscissa. From Figure 2 it is seen that the switching temperature decreases substantially linearly with an increase in resistance of the gate resistor $R_{GA}$ in the logarithmic scale.

Thermally sensitive thyristors such as shown in Figure 1 are used as temperature sensors by utilizing their property that they switch from their OFF to their ON state at the switching temperature. To this end, it is required to switch such a thyristor at the predetermined temperature and also to control that predetermined temperature or the switching temperature to be in a range of from +3° to −3°C and preferably from +2° to −2°C about to the particular predetermined magnitude for practical purposes.

However, the existing methods of manufacturing thermally sensitive thyristors of the *pnpn* junction structure have resulted in switching temperatures being distributed in a range of from +7° to −7°C about the particular predetermined magnitude. If the switching temperatures are selected to be in the required range of from +3° to −3°C about the particular predetermined magnitude then the resulting yield has decreased to from 20 to 30%. This has been one of the causes for which semiconductor thermally sensitive switches increase in cost.

The present invention contemplates to eliminate such a cause by providing a method of manufacturing a semiconductor thermally sensitive switch having a predetermined switching temperature through the utilization of the switching temperature varying with a magnitude of a gate resistance as shown in Figure 2.

Referring now to Figure 3, there is illustrated one embodiment according to the manufacturing method of the present invention. The arrangement illustrated comprises a rectangular thermally sensitive thyristor generally designated by the reference numeral 10 and disposed on one portion, in this case, the lower right-hand portion as viewed in Figure 3 of a ceramic substrate 30. The thyristor 10 has a *pnpn* structure as described in conjunction with Figure 1 and includes an anode electrode 20 located on a great portion of the surface of the element 10 and a gate electrode 24 located on the upper lefthand portion thereof as viewed in Figure 3. The ceramic substrate 30 includes three metallized layers 32, 34 and 36 disposed on that surface thereof on which the thyristor 10 is disposed. In the example illustrated the metallized layer 32 extends along the upper edge portion as viewed in Figure 3 of the ceramic substrate 30 to be spaced from the thyristor 10, and the metallized layer 36 extends along the opposite or lower edge portion of the substrate to oppose to the metallized layer 32 and includes that portion thereof overlaid with the thyristor 10 to be connected to a cathode electrode thereof (not shown) by brazing. The metallized layer 34 is put between the metallized layers 32 and 36 to be spaced from those layers and from the thyristor 10.

The metallized layer 32 is connected to the anode electrode 20 through a connecting lead 38 and provided at that end thereof remote from the thyristor 10 with an anode terminal A and the metallized layer 36 is provided at that end thereof remote from the thyristor 10 with a cathode electrode K. The metallized layer 34 is connected to the gate electrode 24 through a connecting lead 40. Then a gate resistor $R_{GA}$ is disposed on the ceramic substrate 30 to be sandwiched between the metallized layers 32 and 34. The gate resistor $R_{GA}$ is formed into a width W (see Figure 3) according to thick film technique.

The assembly as described above is of the known structure and disclosed, for example, in U.S. patent No. 4,009,48 to J. Nakata assigned to the same assignee as the present application.

This assembly is disposed on a heating block 38a at a temperature controllably maintained at a constant magnitude. A thermocouple designated by a small circle 40a is suitably disposed on the heating block 38a and connected to a thermometer 42 to measure the temperature of the heating block 38a.

A source circuit generally designated by the reference numeral 42a include a battery 44 and a resistor 46 connected in series across the anode and cathode terminals A and K respectively with a voltmeter 48 connected across the resistor 46.

In Figure 3 a sand blasting apparatus 50 is shown as being located above that end of the gate resistor $R_{GA}$ near to the semiconductor thyristor 10.

Upon practicing the present invention the gate resistor $R_{GA}$ is first formed to be sufficiently wide. That is, its width W (see Figure 3) is rendered sufficiently large. Therefore the gate resistor $R_{GA}$ has a sufficiently low magnitude of resistance resulting in a sufficiently high switching temperature of the thyristor 10.

Under these circumstances, the heating block 38a is set to a predetermined switching temperature of the thyristor 10 while the temperature of the heating block 38a is measured by the thermometer 42. At that time, the thyristor 10 is in its OFF state because the gate resistor $R_{GA}$ has the low magnitude of resistance.

In such a situation the sand blasting apparatus 50 is operated to cut the gate resistor $R_{GA}$ so as to decrease its width W. This results in an increase in resistance of the gate resistor $R_{GA}$. As the gate resistor $R_{GA}$ increases in resistance, the thyristor 10 decreases in switching temperature until the predetermined switching temperature is reached. At that time, the thyristor 10 switches to its ON state which can be sensed by the voltmeter 48 indicating a voltage drop across the resistor 46 connected thereacross. When the thyristor 10 switches to its ON state as sensed by the voltmeter 48, the sand blasting apparatus 50 is immediately stopped to be operated. Therefore the thyristor 10 has the desired switching temperature as determined by the resistance provided by the gate resistor $R_{GA}$ just when the sand blasting is stopped.

From the foregoing it is seen that the present invention sets a semiconductor thermally sensitive switch to a predetermined switching temperature by controlling an associated gate resistance. Therefore the present invention can manufacture a semiconductor thermally sensitive switch having any desired switching temperature with a good yield.

While the present invention has been illustrated and described in conjunction with a single preferred embodiment thereof it is to be understood that numerous changes and modifications may be resorted to without departing from the scope of the present invention as defined by the subject-matter of claim 1. For example, while the sand blasting has been used to cut the gate resistor it is to be understood that the gate resistor may be cut by utilizing the vaporization cutting with a laser beam or a laser trimming technique. Also, in the embodiment illustrated, the gate electrode disposed in ohmic contact with the *n* type base layer but the present invention is equally applicable to thermally sensitive semiconductor switches including the gate electrode disposed in ohmic contact with the *p* type base layer. In the latter case it is to be understood that the gate resistor is connected between the gate and cathode electrodes thereof.

**Claims**

1. A method of manufacturing a thermally sensitive semiconductor switch comprising a semiconductor element (10) of the *pnpn* junction structure (12—18) including a gate resistor ($R_{GA}$) connected across a gate electrode (24) disposed in ohmic contact with a central base layer (14) of said semiconductor element (10) and one main electrode (20) disposed in ohmic contact with an emitter layer (12) thereof adjacent to said central base layer (14) which method comprises the steps of forming said gate resistor ($R_{GA}$) of a thick film resistance low in resistance so as to render a switching temperature of said thermally sensitive semiconductor switch (10) higher than a predetermined magnitude, holding said thermally sensitive semiconductor switch (10) at a temperature equal to said predetermined magnitude, cutting (50) said gate resistor ($R_{GA}$) to increase its resistance while a predetermined anode voltage is applied across said semiconductor element (10), and stopping said cutting of said gate resistor ($R_{GA}$) upon said semiconductor (10) thermally sensitive switch changing from its OFF to its ON state thereby to fix the resistance of said gate resistor ($R_{GA}$).

2. A method of manufacturing a semiconductor thermally sensitive switch, as claimed in claim 1 wherein the step of cutting said gate resistor is effected according to sand-blasting technique (50).

3. A method of manufacturing a semiconductor thermally sensitive switch, as claimed in claim 1 wherein the steps of cutting said gate resistor is effected according to laser trimming technique.

**Patentansprüche**

1. Verfahren zur Herstellung eines thermisch empfindlichen Halbleiter-Schalters, bestehend aus einem Halbleiterelement (10) mit einem pnpn-Sperrschichtaufbau (12—18), mit einem Gate-Widerstand ($R_{GA}$), der über eine Gate-Elektrode (24) im ohmschem Kontakt mit einer zentralen Basisschicht (14) des Halbleiterelements (10) und einer Hauptelektrode (20) geschaltet ist, die in ohmschem Kontakt mit einer der zentralen Basisschicht (14) benachbarten Emitterschicht (12) des Halbleiterelements (10) steht, dadurch gekennzeichnet, daß der Gate-Widerstand ($R_{GA}$) aus einem Dickfilmwiderstand mit niedrigem Widerstandswert hergestellt wird, so daß die Schalttemperatur des thermisch empfindlichen Halbleiter-Schalters (10) höher als ein vorgegebener Wert eingestellt wird; daß der thermisch empfindliche Halbleiter-Schalter (10) auf einer dem vorgegebenen Wert entsprechenden Temperatur gehalten wird; daß der Gate-Widerstand ($R_{GA}$) zur Vergrößerung seines Widerstandswerts geschnitten wird (50), während eine vorgegebene Anodenspannung an das Halbleiterelement (10) angelegt wird; und daß das Schneiden des Gate-Widerstands ($R_{GA}$) beendet wird, wenn der thermisch empfindliche Halbleiter-Schalter (10) aus seinem Sperrzustand in den Durchschaltzustand übergeht, so daß der Widerstandswert des Gate-Widerstands ($R_{GA}$) festgelegt wird.

2. Verfahren zur Herstellung eines thermisch empfindlichen Halbleiter-Schalters nach Anspruch 1, dadurch gekennzeichnet, daß das Schneiden des Gate-Widerstands mit einem Sandstrahlverfahren (50) durchgegührt wird.

3. Verfahren zur Herstellung eines thermisch empfindlichen Halbleiter-Schalters nach Anspruch 1, dadurch gekennzeichnet, daß das Schneiden des Gate-Widerstands mit einem Laser-Schneidverfahren durchgeführt wird.

**Revendications**

1. Procédé de fabrication d'un commutateur à semiconducteur thermosensible comprenant un élément à semiconducteur (10) de la structure à jonction *pnpn* (12—18) ayant une résistance de porte ($R_{GA}$) connectée à travers une électrode de porte (24) disposée en contact ohmique avec une couche de base centrale (14) dudit élément à semiconducteur (10) et une électrode principale (20) disposée en contact ohmique avec sa couche d'émetteur (12) à proximité de ladite couche de base centrale (14), lequel procédé comprend les étapes de former ladite résistance de porte ($R_{GA}$) d'une résistance à film épais de faible valeur afin de rendre la température de commutation dudit commutateur à semiconducteur thermosensible (10) supérieure à une grandeur prédéterminée, de maintenir ledit commutateur à semiconducteur thermosensible (10) à une température égale à ladite grandeur prédéterminée, de couper (50) ladite résistance de porte ($R_{GA}$) pour augmenter sa valeur tandis qu'une tension d'anode prédéterminée est appliquée audit élément à semiconducteur (10) et d'arrêter ladite coupure de ladite résistance de porte ($R_{GA}$) lorsque ledit commutateur à semiconducteur thermosensible (10) passe de son état non passant à son état passant pour ainsi fixer la valeur de ladite résistance de porte ($R_{GA}$).

2. Procédé de fabrication d'un commutateur thermosensible à semiconducteur selon la revendication 1 où l'étape de couper ladite résistance de porte est effectuée selon une technique de jet de sable (50).

3. Procédé de fabrication d'un commutateur thermosensible à semiconducteur selon la revendication 1 où les étapes de couper ladite résistance de porte est effectuée selon une technique d'ajustage au laser.

FIG.1

FIG.2

FIG.3